Europäisches Patentamt

European Patent Office

Office européen des brevets

(11) Publication number: **0 633 665 A2**

## (12) EUROPEAN PATENT APPLICATION

(21) Application number: **94201881.3**

(22) Date of filing: **30.06.94**

(51) Int. Cl.6: **H03K 19/094**, H03K 19/14

(30) Priority: **05.07.93 GB 9313842**

(43) Date of publication of application:
**11.01.95 Bulletin 95/02**

(84) Designated Contracting States:
**DE FR GB IT NL**

(71) Applicant: **PHILIPS ELECTRONICS UK LIMITED**
**420-430 London Road**
**Croydon CR9 3OR (GB)**
(84) **GB**

(71) Applicant: **PHILIPS ELECTRONICS N.V.**
**Groenewoudseweg 1**
**NL-5621 BA Eindhoven (NL)**
(84) **DE FR IT NL**

(72) Inventor: **Bird, Neil Christopher**
**c/o Philips Research Labs.,**
**Cross Oak Lane**
**Redhill,**
**Surrey RH1 5HA (GB)**

(74) Representative: **Clark, Jane Anne et al**
**Philips Electronics UK Limited**
**Patents and Trade Marks Department**
**Cross Oak Lane**
**Redhill, Surrey RH1 5HA (GB)**

(54) **An inverter circuit.**

(57) An inverter circuit (Ia) has first and second voltage supply lines (2 and 3), an input signal line signal (I) to be inverted and an output signal line (5) for supplying an inverted output signal (I). A transistor (QI) has a first main electrode (s) coupled to the first voltage supply line (2), a control electrode (g) coupled to the input signal line 4 and a second main electrode (d) coupled to the output signal line (5). A load device (L) coupling the second main electrode (d) of the transistor (QI) to the second voltage supply line (3) is in the form of a photosensitive element (DI,D2) which is illuminated during operation of the inverter circuit so enabling a high output impedance load to be provided without having to use complementary transistors.

FIG.1

This invention relates to an inverter circuit especially but not exclusively to an inverter circuit suitable for use in the control circuitry of a two dimensional active matrix addressed array such as a thin-film, e.g. liquid crystal display, image sensor or memory array.

An important aim in the field of thin film two-dimensional active matrix addressed arrays is to be able to integrate the necessary row and column drive circuitry on the same substrate as the actual array of elements, e.g. display elements, so as to enable reductions in manufacturing complexity, for example to reduce the number of connections between the actual array and the control circuitry, and possibly allow reductions in the area required for the control circuitry etc.

One of the most basic components required to implement the control circuitry is an inverter circuit which forms the building block of control circuitry elements such as shift registers etc. A typical inverter circuit which may be formed, for example, from amorphous or polycrystalline silicon n-channel thin film transistors (TFTs) and can thus be relatively easily integrated on the same substrate as an active matrix addressed array comprises an input n channel TFT having its control electrode coupled to the input signal line which is to receive the signal to be inverted and one of its main (source and drain) electrodes coupled to a first voltage supply line. The other or second main electrode of the input TFT is coupled to one main electrode of a load n-channel TFT and to an output signal line from which the inverted output signal is taken. The other or second main electrode of the load TFT is coupled to a second voltage supply line while its control electrode is coupled either to the second voltage supply line or a separate third voltage supply line. Examples of such inverter circuits are described in many papers, for example, a paper entitled 'Polysilicon TFT active-matrix LCD drivers' by A.G. Lewis, D.D. Lee, R.H. Bruce and Russel A. Martin published in the Society for Information Display (SID) International Symposium Anaheim California, May 6-10, 1991. Digest of Technical Papers Volume XXII at pages 535 to 538, and a paper entitled 'Integrated Shift register with poly CdSe-TFTs for frequencies up to 4MHz' by K. Khakzov, E. Lueder, T. Kallfars, J. Spachmann, J. Glueck and W. Otterbach published at pages 312-314 in the Proceedings of Eurodisplay 190, the Tenth International Display Research Conference held on 25-27 September 1990 in the Netherlands.

Such an inverter circuit functions as follows. The input TFT operates in its saturation region and the input signal at its gate causes a drain current to flow. This drain current also flows through the load TFT and the resulting gate-source voltage of the load TFT determines the voltage at the output line.

Thus, for increasing voltage at the input line, the voltage at the output line falls.

Ideally, the load TFT should have a very high output impedance to provide a transfer characteristic close to the ideal. However, in the above-described inverter circuit, the output impedance of the load TFT is neither very high nor is it constant because the gate-source voltage of the load TFT is modulated by the output voltage of the inverter. Accordingly, the obtained transfer characteristic is not ideal. The small signal gain of this inverter circuit is given by

$$G = \frac{gm}{go}$$

which for an n-channel load TFT becomes

$$G = \sqrt{\frac{\frac{W_1}{L_1}}{\frac{W_2}{L_2}}}$$

where W1 and W2 are the widths of the channels of the input and load TFT, respectively, L1 and L2 are the channel lengths of the input and load TFTs, gm is the mutual conductance of the input TFT and go is the output conductance of the inverter circuit.

By analogy with bulk semiconductor integrated circuit technology, in principle, a higher gain inverter circuit can be made using p-channel TFTs, for example as described in a paper entitled 'on the poly-CdSe thin film transistor technology' by A.van Calster, J. De Baets, I. De Rycke, J. Doutreloigne, H.De Smet and J. Vanflekeren published at pages 408-411 of the proceedings of the 9th International Display Research Conference October 16-18 in Kyoto Japan. However p-channel TFTs with adequate performance, particularly with acceptable threshold voltages, are difficult to make in non-single crystal (e.g. amorphous or polycrystalline) silicon and the mobility is of course lower than that of n-channel TFTs so that the resulting circuits would be slower.

It is an aim of the present invention to provide an inverter circuit which has improved characteristics compared to that described above wherein the inverter circuit comprises an input n-channel TFT and a load n-channel TFT.

According to one aspect of the present invention, there is provided an inverter circuit comprising first and second voltage supply lines, an input signal line for receiving an input signal to be inverted and an output signal line for supplying an inverted output signal, a transistor having first and second main electrodes and a control electrode with the first main electrode coupled to the first voltage supply line, the control electrode coupled to the input signal line and the second main electrode coupled to the output signal line and a load device coupling the second main electrode of the transistor to the second voltage supply line, characterised in that the load device comprises a photosensitive element which is illuminated during operation of the inverter circuit.

An inverter circuit in accordance with the invention thus enables a high output impedance load to be provided without having to use complementary transistors and so enables circuits to be formed using only one conductivity type of transistor, for example using only n channel TFTs.

Any suitable form of photosensitive element may be used. For example the photosensitive element may be a photosensitive non-linear resistive element such as a pn or p-i-n diode, a Schottky diode or a metal-insulator-metal thin film diode.

In one example the photosensitive element comprises a photosensitive non-linear resistive device which is coupled between the second main electrode of the transistor and the second voltage supply line. In such a circuit, the photocurrent generated due to the illumination of the photosensitive device can be independent of the reverse-bias voltage applied across the photosensitive device so that the device has a very high output impedance. The gain of the inverter circuit is thus determined by the output impedance of the transistor.

In operation of a circuit in accordance with this example, the photosensitive element will generate a photocurrent which is independent of the voltages to which the photosensitive element is subjected, that is the photosensitive element has a very high impedance which should enable the inverter circuit to achieve a small signal gain which is much higher than that of the above-described known inverter circuit so enabling the transfer characteristic to be closer to the ideal and thus reducing the required noise margins for logic circuits constructed using an inverter circuit in accordance with the invention.

An inverter circuit in accordance with this example has indeed been found to have a much improved transfer characteristic.

In a second example of a circuit in accordance with the invention the load device comprises a load transistor having first and second main electrodes and a control electrode with the first main electrode of the load transistor coupled to the second main electrode of the transistor and the second main electrode of the load transistor coupled to the second voltage supply line and the photosensitive element is coupled between the control electrode and the first main electrode of the load transistor so that the photosensitive element, when illuminated, provides a voltage between the control and first main electrode of the load transistor.

In this second example, the gate-source voltage of the load transistor is not a function of the inverter output voltage and so the inverter circuit has an increased output impedance, giving a higher gain and a closer to ideal transfer characteristic. In operation of such a circuit, illumination of the photosensitive element results in a small voltage across the photosensitive element which voltage is equal to the forward bias required to give a forward current equal in magnitude to the photocurrent.

Generally, but depending upon the characteristics of the photosensitive element, in this second example the photosensitive element will comprise a series of photosensitive devices to enable sufficient voltage to be provided to turn on the load transistor when the photosensitive element is illuminated. In an inverter circuit in accordance with this second example, the current flowing in the inverter circuit, that is that which is available to charge the load capacitance, is not determined by the current flowing through the photosensitive element when the output voltage of the inverter circuit is rising. Accordingly, with an inverter circuit in accordance with the second example, larger capacitive loads can be driven at the same given flow rate by either increasing the channel width to length W/L ratio of the load transistor or by adding photosensitive devices to the series chain coupled between the control and first main electrode of the load transistor. It should not however be necessary to increase the size or area of the photosensitive devices because they are not required to produce an output current.

Although an inverter circuit in accordance with the invention could be manufactured using bulk semiconductor technology, the present invention is particularly intended for use in thin film technology where the photosensitive element may comprise at least one thin film diode, for example a p-i-n diode a Schottky diode or a metal-insulator-metal (MIM) device, while the or each transistor may comprise an n-channel thin film transistor.

In another aspect, the present invention provides a two-dimensional array comprising storage elements arranged in rows and columns, row and column conductors for accessing individual ones of the storage elements and control circuitry for controlling access of the storage elements by means of the row and column conductors, the control circuitry comprising at least one inverter circuit in accordance with the first aspect.

The storage elements could be for example memory elements so that the array forms a memory array, display elements for example liquid crystal display elements and/or imaging elements in the form of further photosensitive sensing elements.

Where a light source is provided for illuminating the array, for example the back light in the case of a liquid crystal display, then that light could be used for illuminating the photosensitive elements. Alternatively a separate light source could be used and the light source could be switchable by, for example, the use of a liquid crystal shutter to enable the inverter circuits to be switched between an active and an inactive state by switching the light on and off to facilitate power savings.

In another aspect, the present invention provides a circuit comprising an enhancement mode field effect transistor having first and second main electrodes and a control electrode and photosensitive charge storage means coupled to the gate electrode for modifying the threshold voltage of the transistor in response to light incident on the charge storage means.

The charge storage means may comprise one or more photosensitive diodes coupled between the gate and one of the first and second main electrodes of the transistor. In such a case, the number of diodes determines the degree to which the threshold voltage is adjusted.

A circuit in accordance with said other aspect enables the threshold voltage of the enhancement mode (normally off until an appropriate gate voltage is applied) field effect transistor to be adjusted as required in response to light without having to alter the dopant concentration of the channel region or, in the case of an insulated gate field effect transistor, the thickness of the gate dielectric. This enables a circuit comprising a number of transistors which require different threshold voltages to be formed simultaneously using the same process steps on the same substrate, for example by thin film technology on an insulative substrate, without the necessity for any additional masking or other process steps. Moreover, the fact that the threshold voltage is adjusted in response to incident light enables the same transistor to be operated with two different threshold voltages, one threshold voltage when the photosensitive charge storage means are illuminated and the other when the photosensitive charge storage means are not illuminated. For example, the photosensitive charge storage means may be arranged to modify the threshold voltage so that the transistor acts as a depletion (normally on until an appropriate gate voltage is applied) transistor when the photosensitive charge storage means are illuminated. Such a circuit may be used to advantage in a device which already requires a light source or illumination by ambient light, for example in control circuitry for a device such as a display, for example a liquid crystal display, or an image sensor.

Embodiments of the invention will now be described, by way of example, with reference to the accompanying drawings, in which:

Figure 1 is a circuit diagram of a first embodiment of an inverter circuit in accordance with the invention;

Figure 2 illustrates an experimentally obtained transfer characteristic for the inverter circuit shown in Figure 1;

Figure 3 is a circuit diagram of a second embodiment of an inverter circuit in accordance with the invention;

Figure 4 is a block schematic circuit layout for a two-dimensional array of storage elements suitable for incorporating one or more inverter circuits in accordance with the invention;

Figure 5 illustrates an example of a shift register suitable for use in control circuitry of a two-dimensional active matrix array and formed using the inverter circuit shown in Figure 3;

Figure 6 is a timing diagram for illustrating the operation of the shift register shown in Figure 5; and

Figure 7 is a very schematic simplified view through part of the periphery of a two-dimensional active matrix array having control circuitry incorporating at least one inverter circuit in accordance with the invention.

It should of course be understood that the drawings are merely schematic and not to scale. Like reference numerals are used throughout to refer to like parts.

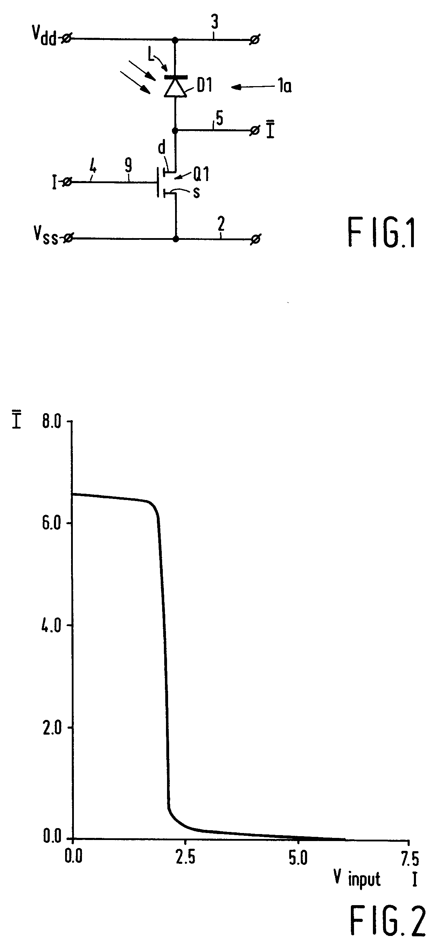

Referring now to the drawings, especially Figures 1 and 2 an inverter circuit la,lb comprises first and second voltage supply lines 2 and 3, an input signal line 4 for receiving an input signal I to be inverted and an output signal line 5 for supplying an inverted output signal I, a transistor QI having first and second main electrodes s and d and a control electrode g with the first main electrode s coupled to the first voltage supply line 2, the control electrode g coupled to the input signal line 4 and the second main electrode d coupled to the output signal line 5 and a load device L coupling the second main electrode d of the transistor QI to the second voltage supply line 3.

In accordance with the invention, the load device L comprises a photosensitive element D1,D2 which is illuminated during operation of the inverter circuit.

An inverter circuit in accordance with the invention thus enables a high output impedance load to be provided without having to use complementary transistors and so enables circuits to be formed using only one conductivity type of transistor, for example using only n channel TFTs.

In the example illustrated in Figure 1, the transistor QI is an n-channel thin film transistor (TFT) and the photosensitive element DI forms the load L and comprises a two-terminal photosensitive non-linear resistive device such as a p-i-n diode which has its cathode coupled to the second voltage supply line 3 and its anode coupled to the second main electrode d of the transistor QI so as to be reverse-biassed in operation of the inverter circuit la.

In operation of the inverter circuit la, a first voltage Vss is applied to the first voltage supply line 2, a second voltage Vdd is applied to the second voltage supply line 3 and the input signal voltage I is applied to the input signal line 4.

The inverter circuit la is inactive until the photosensitive diode DI is illuminated. The illumination of the photosensitive diode DI generates a photocurrent which is independent of the reverse-biassing of the photosensitive diode DI. The photosensitive diode DI thus has a very high output impedance so that the gain of the inverter circuit la is determined by the output impedance of the TFT QI.

Figure 2 illustrates an experimentally obtained transfer characteristic for the inverter circuit la shown in Figure 1 where the x axis indicates the input voltage I in volts and the y axis indicates the output voltage I in volts. As can be seen clearly from Figure 2 a very steep rear ideal step from an output voltage of close to zero to an output voltage of just over six volts occurs at an input voltage I of about 2.5 volts. This circuit la has a small signal gain of 30: to achieve a comparable gain with the two n-channel TFT circuit discussed in the introduction above would require a channel width to length W:L ratio of 900.

Thus, in operation of the inverter circuit la shown in Figure 1, the photosensitive element D1,D2 will generate a photocurrent which is independent of the voltages to which the photosensitive element is subjected, that is the photosensitive element has a very high impedance which should enable the inverter circuit la,lb to achieve a small signal gain which is much higher than that of the above-described known inverter circuit so enabling the transfer characteristic to be closer to the ideal and thus reducing the required noise margins for logic circuits constructed using an inverter circuit la,lb in accordance with the invention.

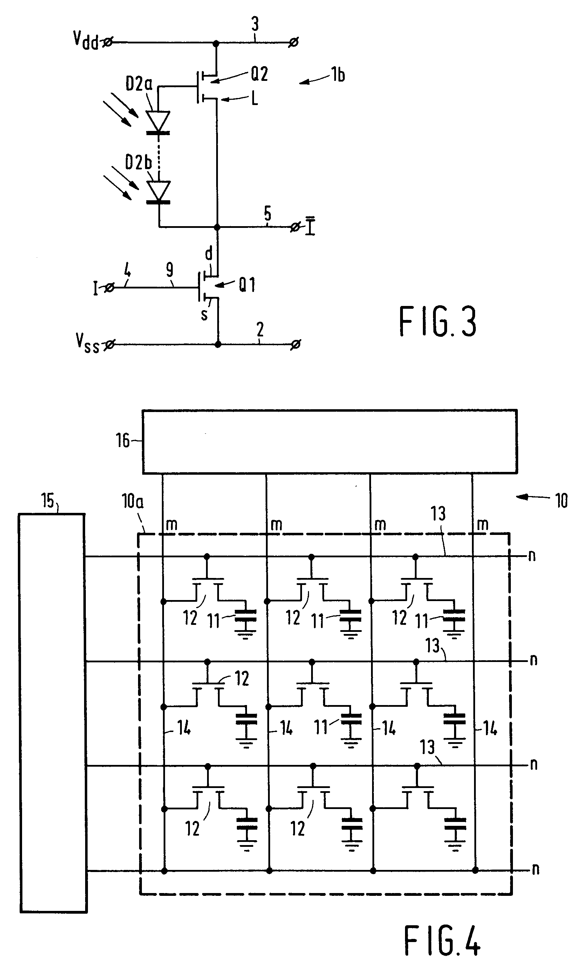

Figure 3 shows a second example of an inverter circuit lb in accordance with the invention. In the example shown in Figure 3, the transistor QI again comprises an n-channel TFT. In this case however, the second main electrode d of the TFT QI is coupled to the output signal line 5 and to the first main electrode s of a load transistor, also in the form of an n-channel TFT, Q2. The second main electrode d of the load TFT Q2 is coupled to the second voltage supply line 3.

A series or chain of photosensitive devices D2, again in this example photosensitive p-i-n diodes, is coupled between the control or gate electrode and the first main or source electrode s of the load TFT Q2 so that each photosensitive diode D2 has its anode coupled to the cathode of the adjacent diode with the first diode D2a of the series having its anode coupled to the control electrode g and the last diode D2b of the series having its cathode coupled to the first main electrode s of the load transistor Q2.

In this example, in operation of the inverter circuit lb, the first and second voltages Vss and Vdd are applied to the first and second voltage supply lines 2 and 3 as described above. In this case, however, the gate-source voltage of the load TFT Q2 is provided by the series or stack of photosensitive diodes D2 when the photosensitive diodes D2 are illuminated.

As the gate-source voltage of the load TFT Q2 is not a function of the inverter output voltage I, the output impedance of the inverter circuit lb is increased relative to that of the conventional two n-channel TFT inverter circuit described above and accordingly a closer to ideal transfer characteristic is obtained.

The small voltage drop across each photosensitive diode D2 is equal to the forward bias required to give a forward current equal in magnitude to the photocurrent. The number of photosensitive diodes D2 required will depend upon the characteristics of the photosensitive diodes D2 and the particular required characteristics of the inverter circuit lb (for example there may only be one photosensitive diode D2) but should of course be sufficient to provide a sufficient gate-source voltage to turn on the load TFT Q2.

An inverter circuit la,lb in accordance with the invention enables a much higher small signal gain to be achieved than with the conventional two n-channel TFT circuit described in the introduction. A higher small signal gain of course means that the transfer characteristic will be closer to the ideal and this is especially important when several inverter circuits are coupled together in a logic chain because a sloping characteristic would progressively degrade the noise margin of the complete logic chain. In the example illustrated in Figure 1, the inverter circuit la can be made to drive larger capacitive loads at the same given slow rate by increasing the size (area) of the photosensitive diode D1 to provide the necessary higher current. In the inverter circuit lb illustrated in Figure 3, larger capacitive loads can be driven by either increasing the channel width to length W/L ratio of the load TFT Q2 or adding extra photosensitive diodes D2. Thus in the example illustrated in Figure 3, the individual photosensitive diodes DL can be small, which provides a space saving, because they are not required to produce an output current.

Although in the example described above, the inverter circuits la,lb are intended to be formed in thin film technology, the present invention could be applied to inverter circuits formed in other technologies, for example bulk silicon technology, although the present invention is particularly advantageous in thin film non-single crystal technology where manufacture of satisfactory p channel TFTs is difficult. An inverter circuit in accordance with the invention may be used in any suitable situation in which a conventional inverter circuit would be used, for example in the formation of logic components such as NAND and NOR gates, flip flops etc. and shift registers and combinations thereof. Some examples of applications for the inverter circuits la and lb shown in Figures 1 and 3 using thin film technology will now be described with the help of Figures 4 to 9.

The circuit formed by the transistor Q2 and diodes D2 may be used to advantages in larger circuits other than inverter circuits such as those described above. Thus, the diodes D2 form photosensitive charge storage means coupled to the gate electrode for modifying the threshold voltage of the transistor in response to light incident on the charge storage means. This enables the threshold voltage of the enhancement mode (normally off until an appropriate gate voltage is applied) field effect transistor Q2 to be adjusted as required in response to light incident on the diodes D2 without having to alter the dopant concentration of the channel region or, in the case of an insulated gate field effect transistor, the thickness of the gate dielectric.

This allows a circuit comprising a number of transistors which require different threshold voltages to be formed simultaneously using the same process steps on the same substrate, for example by thin film technology on an insulative substrate, without the necessity for any additional masking or other process steps. Moreover, the fact that the threshold voltage is adjusted in response to incident light enables the same transistor to be operated with two different threshold voltages, one threshold voltage when the photosensitive charge storage means are illuminated and the other when the photosensitive charge storage means are not illuminated. In this example, the photosensitive diodes D2 modify the threshold voltage so that the transistor acts as a depletion (normally on until an appropriate gate voltage is applied) transistor when the photosensitive charge storage means are illuminated and the current supplied by the transistor is determined by the number of photosensitive diodes D2. Such a circuit may be used to advantage in a device which already requires a light source or illumination by ambient light, for example in control circuitry for a device such as a display, for example a liquid crystal display, or an image sensor. Of course, other forms of photosensitive charge storage means may be used for this purpose and the modification of the threshold voltage caused by illumination of the diodes D2 need not necessarily change an enhancement mode transistor into a depletion mode transistor but may just adjust the threshold voltage.

Figure 4 is a very schematic diagram for illustrating a two-dimensional active matrix addressed array 10 having an active area 10a and having control circuitry suitable for incorporating inverter circuits in accordance with the invention.

As shown in Figure 4, the active area 10a of the array 10 comprises an array of storage elements 11 arranged in rows and columns n and m.

Each storage element 11 may be for example a display element where the array 10 forms an electro-optic, e.g. liquid crystal, display, a memory element such as a transistor, or a photosensitive element such as a p-i-n diode where the array forms an image sensor. Of course, the array 10 would combine two or more of these functions by providing different types of storage elements 11.

The storage elements 11 are illustrated simply as capacitances in Figure 4. This capacitance will be the capacitance of the display element in the case of a display, the intrinsic photodiode (plus any additional capacitance) capacitance in the case of an image sensor and the storage capacitance of a memory element in the case of a thin film memory.

In the example illustrated, one plate of each capacitance 11 is coupled to a common electrode held at a reference potential which may, as illustrated, be earth while the other plate is coupled to one of the main electrodes of an n-channel TFT switching element 12. The gate or control electrodes g of all the TFTs 12 associated with a row n of storage elements 11 are coupled to the same row conductor 13 while the other main electrodes of all the TFTs associated with a column m of storage elements 11 are coupled to the same column conductor 14. Row and column addressing circuitry 15 and 16 are provided to enable each storage element to be accessed individually via the switching element TFTs 12. The actual nature of the row and column addressing circuits 15 and 16 will of course depend upon the precise nature of the array, for example whether it is a display or image sensor with, in the former case, the column addressing circuits being required to supply video signal information to the array and in the latter case to enable read-out of charge stored at the photosensitive elements. Examples of row and column addressing circuitry for these two instances may be found in many publications. Thus, for example, reference may be made to EP-A-391655 or GB-A-2186414 for example of methods of driving a liquid crystal display while reference may be made, for example, to US-A-5003167 or US-A-4382187, or US-A-4945243, for example for examples of methods of driving image sensors. It will be evident to those skilled in the art that other types of switching elements (diodes, TFDs etc.) may be used (see, for example, US-A-4945243 or EP-A-233104) and that other circuit layouts may be possible. Also, although only a 3 by 3 active area 10a matrix array of storage elements 11 has been shown in Figure 4 in practice the array will consist of many more storage elements, with the actual number depending upon the desired application.

As will be evident to those skilled in the art and from an examination of the disclosures of the above-mentioned documents, one of the most commonly required circuits for use in the control circuitry of a two dimensional active matrix addressed array is a shift register.

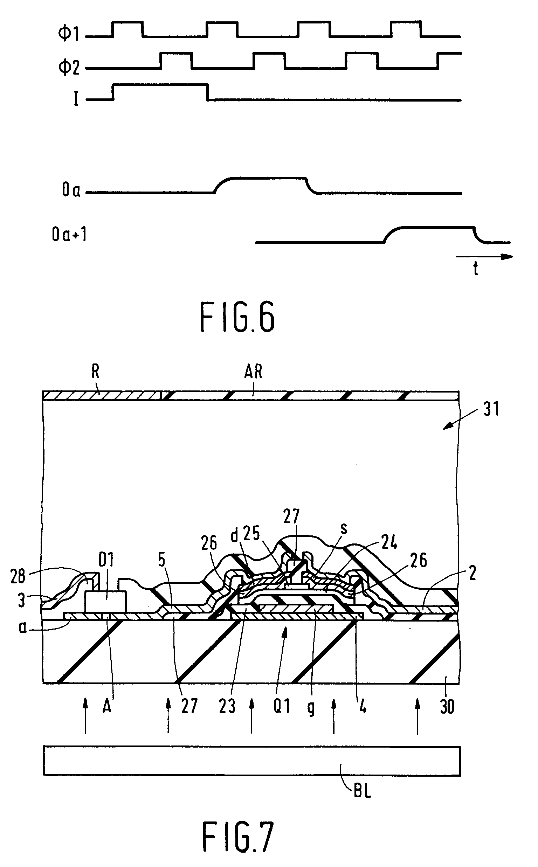

Figure 6 illustrates one example of a shift register 20 formed using the inverter circuit Ib shown in Figure 3.

As can be seen from Figure 6, the shift register 20 has a number of stages $20_a$ to $20_y$ where the number of stages is determined by the number of outputs 0 required for the shift register. Thus, for example, where the shift register 20 forms part of the row addressing circuitry of a two-dimensional matrix addressed array such as a display or image sensor then the number of outputs 0 will equal the number of row or column conductors, as the case may be.

Each stage $20_a$... $20_y$ consists of two inverter circuits Ib and two pass transistors, again in this example n channel TFTs, Q3 and Q4 and an output transistor Q5. The first pass transistor Q3 of each stage has its main current path coupled between the input (that is either the initial input Io to the shift register or the output from the previous stage) and its control or gate electrode g coupled to a first clock signal $\phi 1$ supply line 21. The second pass transistor Q4 of each inverter stage $20_a$.... $20_y$ has its main current path coupled between the output 5 of the first inverter Ib' of that stage $20_x$ and the input 4 the second inverter Ib'' of that stage and its control electrode g coupled to a second clock signal $\phi 2$ supply line 22.

The output of the second inverter circuit Ib'' of each stage $20_a$... $20_{y-1}$ is coupled to the input line 4 of the first inverter circuit Ib' of the next stage $20_{a+1}$ .... $20_y$ to provide the input signal $I_{a+1}$ .... $I_y$ and to one of the first and second main electrodes s and d of the output transistor Q5, the gate electrode of which is coupled to the first clock

signal $\phi 1$ supply line 21. The other main electrode of the output transistor Q5 provides the output signal $O_a$ .... $O_y$ to, for example, a row or column conductor of an LCD display device via, possibly, a suitable buffer circuit.

Figure 6 is a timing diagram showing the changes with time in the clock signals $\phi 1$ and $\phi 2$, the input signal I and the selected ones of the output signals $O_a$ , $O_{a+1}$ from which the operation of the shift register 20 should be clear. Thus, when the first clock signal $\phi 1$ is high, the pass transistor Q3 is rendering conducting and the voltage I at the input to the stage $20_x$ is transferred to the input of the first inverter circuit Ib' of that stage. The output 5 of the first inverter circuit Ib' changes to the opposite logical level I and when the second clock signal $\phi 2$ goes high, the second pass transistor Q4 is rendered conducting and the output (node NI) of the first inverter circuit Ib' is transferred to the input 4 of the second inverter circuit Ib'' of that stage. The output 5 of the second inverter circuit Ib'' (node N2) then is changed to the initial logical level I which was input to the stage $2O_x$ and on the following first clock signal $\phi 1$ the first pass transistor Q3 of the next stage $20_{x+1}$ and the output transistor Q5 of the current stage $20_x$ are rendering conducting so that the logical signal I is supplied to the output line $O_x$ and to the next stage $20_{x+1}$ of the shift register and so the process repeats.

As is known in the art, the shift register 20 may be provided with any suitable form of output stage or driver to supply sufficient current to charge and discharge the capacitance of the rows of the array in an acceptable time.

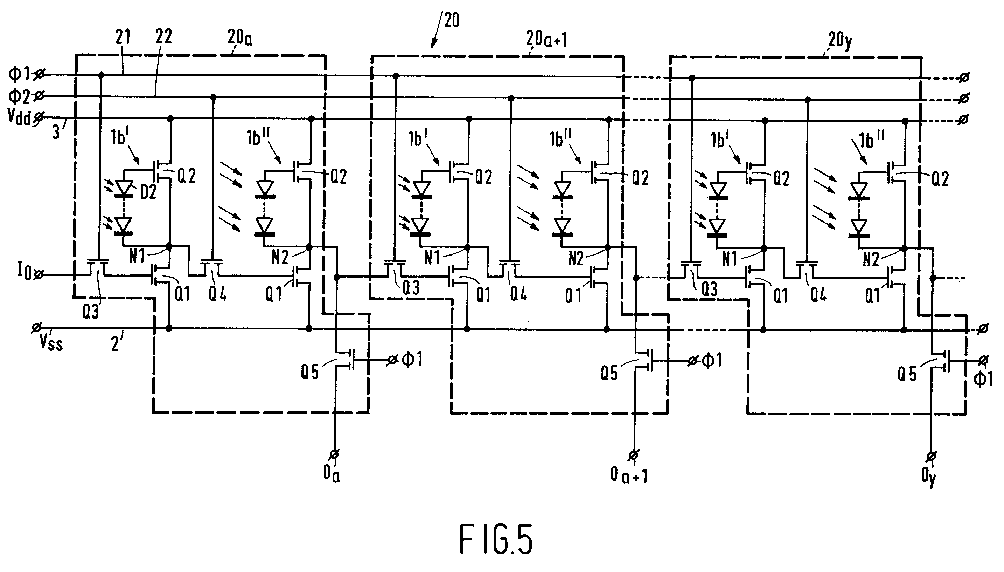

Although Figure 5 shows the use of the inverter circuit Ib to form the shift register, it will be appreciated that the inverter circuit Ia could be used in its place. Although the inverter circuit Ia has advantages in being simple, the inverter circuit Ib should provide a better performance because of the decoupling of the output current of the inverter circuit from the photosensitive diode current.

As should have been appreciated from the above description, the photosensitive element D1 or D2 of the inverter circuit Ia or Ib is illuminated throughout the active operation of the inverter circuit Ia or Ib. Such illumination may be achieved by, for example, providing a light source such as an LCD or LED array or the like close to the photosensitive elements DI or D2. Thus, where the inverter circuit Ia or Ib forms part of control circuitry associated with a two-dimensional array, the light source may be incorporated within the housing of the array.

Figure 7 illustrates very schematically and in simplified form part of the periphery of an active matrix addressed array in which an inverter circuit Ia in accordance with the invention is formed. In this example, at least part of the control circuitry is integrated on the same substrate 30 as the active area (not shown) of the array and is formed using the same thin film technology. The transistors Ql to Q5 used within the inverter circuits (and any others) may have a similar construction to that of any switching transistors, for example the transistors 12 shown in Figure 4, of the active matrix array, although it is possibly desirable that where the control circuitry needs to have relatively high current handling capability then the control circuitry TFTs will be formed of polycrystalline silicon (for example) while the switching transistors 12 may be formed of amorphous silicon. This would be achieved by deposition of separate layers or by using known recrystallisation techniques. Figure 7 shows an inverted staggered construction for the transistor Ql. Thus, the transistor has a, generally, chromium gate electrode g provided on a conductive track, generally chromium, providing the input line 4. A gate insulating layer 23, generally silicon nitride, covers the gate electrode g and is itself covered by an intrinsic (not-intentionally doped) semiconductor, generally polycrystalline silicon, conduction channel-forming layer 24 by conventional deposition and lithographic techniques. A conventional etch stop insulating region 25 is provided over a central area of the channel-forming layer 24 and then n conductivity doped semiconductor regions 26 and source and drain electrode (generally chromium) regions s and d are deposited and defined over which is provided an insulating layer 27 through which contact windows are formed to allow a metallisation layer, generally chromium plus aluminium to be deposited and defined to provide the output line 5 and the voltage supply line 2. The output line 5 also provides the anode electrode a of the photosensitive diode D1 which is generally formed as an n-i-p amorphous diode by depositing and patterning semiconductor, generally silicon, layers. A further, again generally silicon nitride, layer 28 is then deposited and patterned and further metallisation deposited and patterned to define the second voltage supply line 3.

As will be appreciated by those skilled in the art one or more of the insulation, semiconductor and metallisation layers may also be used, with appropriate masking and etching techniques to define appropriate parts of the active area of the array.

As the inverter circuit is in the periphery of the array the structure is covered by an insulating layer indicated generally as 31 which may simply be a passivating layer, generally of silicon nitride, polyimide or another suitable insulator transparent to the wavelengths to which the image sensor is to be responsive. Where the array is, for example, a liquid crystal display then the active area (not shown) will of course have the usual components including a liquid crystal layer and appropriate electrodes and polarisers.

Where the array is an image sensor for viewing relatively distant objects/scenes then the ambient light incident on the array may be sufficient to illuminate the photosensitive elements D1,D2. Where the image sensor is a contact image sensor, is where a document to be imaged is placed directly on top of the active area then the document is illuminated by light from a backlight BL (indicated schematically as a block in Figure 7) through transparent areas of the substrate as explained in for example EP-A-163956 or US-A-5003167 and the photosensitive elements DI,D2 may be similarly illuminated either by forming apertures A in their anode electrodes 40 as shown in Figure 7 and/or by providing a reflective layer R over the appropriate areas of the surface of the layer 30 to reflect light back down onto the top surface of the photosensitive elements DI,D2 with other regions of the control circuitry protected by an anti-reflective layer AR. A system similar to the latter may be used where the array is a liquid crystal display. Where the illumination of the photosensitive elements D1,D2 is via an apertured lower electrode then the top surfaces thereof may be completely covered so as to be shielded from any scattered or directly incident light. The passivating layer 31 (or a subsequent layer) may be shaped to define a microlens array in a manner similar to that described in, for example, EP-A-154962 so that there is a lens element over each photosensitive diode DI or D2 in the peripheral region and so that the reflective layer R forms, for each photosensitive diode, a respective concave mirror for reflecting and concentrating light transmitted through the substrate 30 onto the photosensitive elements D1,D2.

Where the anode electrodes 40 are formed with apertures A then a microlens array could be provided on the back of the substrate 30 so that each photosensitive diode D1,D2 is associated with a respective microlens to concentrate light onto the anode.

Of course, illumination (e.g. by the light source BL) is necessary for the inverter circuits la,lb to be operational and accordingly if required a switchable light source (which would in that case need to be separate from any backlight) could be used to switch an inverter circuit la,lb between an active and an inactive state so as to enable power savings. The switchable light source could be achieved by using a liquid crystal or other similar shutter.

Of course the present invention could be applied, especially if formulated in bulk rather than thin film technology, to the situation where the transistors are p-channel transistors with appropriate charges of voltage polarity etc. although such circuits would inevitably be slower in operation.

From reading the present disclosure, other modifications and variations will be apparent to persons skilled in the art. Such modifications and variations may involve other features which are already known in the semiconductor art and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

**Claims**

1. An inverter circuit comprising first and second voltage supply lines, an input signal line for receiving an input signal to be inverted and an output signal line for supplying an inverted output signal, a transistor having first and second main electrodes and a control electrode with the first main electrode coupled to the first voltage supply line, the control electrode coupled to the input signal line and the second main electrode coupled to the output signal line and a load device coupling the second main electrode of the transistor to the second voltage supply line, characterised in that the load device comprises a photosensitive element which is illuminated during operation of the inverter circuit.

2. An inverter circuit according to Claim 1, wherein the photosensitive element comprises a photosensitive non-linear resistive device which is coupled between the second main electrode of the transistor and the second voltage supply line.

3. An inverter circuit according to Claim 1, wherein the load device comprises a load transistor having first and second main electrodes and a control electrode with the first main electrode of the load transistor coupled to the second main electrode of the transistor and the second main electrode of the load transistor coupled to the second voltage supply line and the photosensitive element is coupled between the control electrode and the first main electrode of the load transistor so that the photosensitive element, when illuminated, provide a voltage between the control and first main electrode of the load transistor.

4. An inverter circuit according to Claim 3, wherein the photosensitive element comprises a series of photosensitive non-linear resistive devices coupled between the control electrode and the first main electrode of the load transistor.

5. An inverter circuit according to any one of the preceding claims, wherein the photosensitive element comprises at least one thin film diode.

6. An inverter circuit according to Claim 5, wherein the or each thin film diode comprises a p-i-n diode.

7. An inverter circuit according to Claim 5 or 6, wherein the or each transistor comprises an n-channel thin film transistor.

8. A two-dimensional array comprising storage elements arranged in rows and columns, row and column conductors for accessing individual ones of the storage elements and control circuitry for controlling access of the storage elements by means of the row and column conductors, the control circuitry comprising at least one inverter circuit in accordance with any one of Claims 1 to 7.

9. A two-dimensional array according to Claim 8, wherein the storage elements comprise display elements.

10. A two-dimensional array according to Claim 8 or 9, wherein the storage elements comprise further photosensitive sensing elements.

11. A two-dimensional array according to Claim 8, 9 or 10, wherein a light source is provided for illuminating the array and the light source also serves to illuminate the photosensitive element.

12. A circuit comprising an enhancement mode field effect transistor having first and second main electrodes and a control electrode and photosensitive charge storage means coupled to the gate electrode for modifying the threshold voltage of the transistor in response to light incident on the charge storage means.

13. A circuit according to Claim 12, wherein the charge storage means comprises one or more photosensitive diodes coupled between the gate and one of the first and second main electrodes of the transistor.

FIG.1

FIG.2

EP 0 633 665 A2

FIG.3

FIG.4

12

FIG.5

FIG.6

FIG.7